Europäisches Patentamt

(19) European Patent Office

Office européen des brevets

(11) Publication number: **0 182 504**
A2

(12) **EUROPEAN PATENT APPLICATION**

(21) Application number: **85307599.2**

(22) Date of filing: **22.10.85**

(51) Int. Cl.⁴: **H 05 K 13/00**

(30) Priority: **15.11.84 US 671397**

(43) Date of publication of application: **28.05.86**
**Bulletin 86/22**

(84) Designated Contracting States: **CH DE FR GB IT LI NL**

(71) Applicant: **MOLEX INCORPORATED, 2222 Wellington**
**Court, Lisle Illinois 60532 (US)**

(72) Inventor: **Slavicek, Donald, 1S-536 Westview Lane,**
**Lombard Illinois 60148 (US)**

(74) Representative: **Slight, Geoffrey Charles et al, Graham**
**Watt & Co. Riverhead, Sevenoaks Kent TN13 2BN (GB)**

(54) **An assembly of flexible carrier and solid components, and methods and apparatus for making and for handling same.**

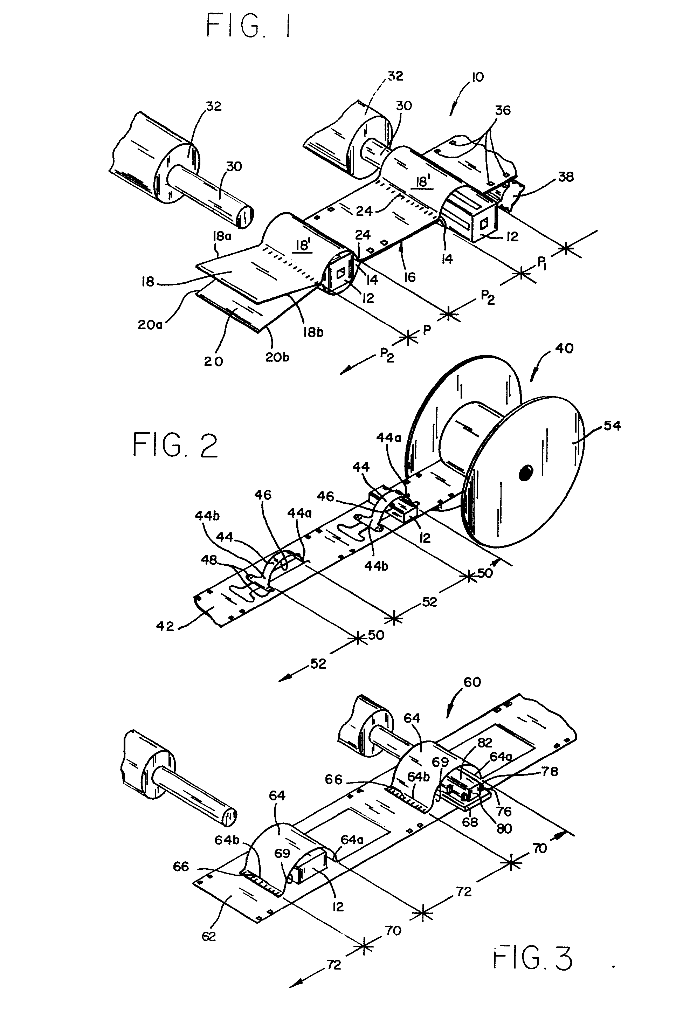

(57) A flexible substrate assembly (10) includes an elongated flexible substrate (16) having a plurality of spaced apart component receiving regions (P1), with a solid component (12) disposed on each of said regions. A plurality of flexible strap members (18') are disposed adjacent each component receiving region on one side thereof, and are joined to the other side of the region such that the strap overlies the region to form a tube-like passageway (14) for receiving and containing a solid component (12). Different configurations of strap members (44 or 64 or 92) (see Figs. 2, 3 and 4) are punched out from a single sheet of flexible substrate so as to form the tube-like passageway in further embodiments. Also disclosed are methods for fabricating the substrate assembly and for dispensing solid components (12) from the substrate assembly. Also, packaging arrangements and apparatus for making the packaging arrangements including the flexible substrate assembly are disclosed.

## AN ASSEMBLY OF FLEXIBLE CARRIER AND SOLID COMPONENTS, AND METHODS AND APPARATUS FOR MAKING AND FOR HANDLING SAME.

The present invention is directed to the handling of solid components and to an assembly of flexible carrier and the components and methods and apparatus for making and handling such assemblies.

An assembly of the invention may form a packaging system for electrical connectors having rigid pin-like terminal means projecting therefrom.

In the past, solid components such as electrical connectors have been packaged in bulk by filling a plastic bag or other suitable container with a number of components in contact with each other in a random mannner. However, bulk packaging is unsuitable in many applications since the solid components are subjected to damage during transport. Another more time consuming and expensive method of packaging electrical connectors has been performed by manually aligning the connectors in layers in a suitable container (such as a cardboard box), to minimize contact between the connectors during storage. A layer of compressible material is sometimes disposed between each layer of hand packed components to minimize damage to them during transport. In yet another method, solid members are disposed end-to-end in a tube of plastics material, but this method is relatively expensive compared to the installed cost of the solid components being packaged.

The applicants have described still another method in EPA No. 85 301525.3 filed 6th March 1985. In this method, connectors or other electrical components having a plurality of rigid pin-like projections are mounted for transport by inserting the pin-like projections in a carrier member which is typically comprised of a polymeric foam or the like material. However, this carrier material comprises a porous medium which readily accepts and retains certain contaminants which tend to deteriorate the electrical contact quality of the rigid pin-like projections, which comprise, for example, integrated circuit terminals.

Further, with increasing miniaturization of electrical components, and the related requirements of more exacting conductive properties of electrical terminals, insertion and withdrawal of the terminals into a porous carrier presents a significant risk of damage or deterioration to those terminals.

The present invention provides from one aspect, a flexible substrate assembly comprising:

a plurality of flexible strap means, each having one end adjacent each region on one side thereof and a second end adjacent the opposite side of said region integrally joined by a connecting portion overlying said region and to form a tube-like passageway for receiving and containing said components.

The present invention also provides a method of manufacturing the flexible substrate assembly of the invention including the steps of:

(a) presenting a component receiving region of said substrate at a work station;

(b) striking the connecting portion of said flexible strap means from said substrate so that the first end remains attached to the substrate and the second end is a free end;

(c) placing said solid component on the component receiving region;

(d) positioning the free end of the strap means over the component;

(e) joining the free end of said strap means to said flexible substrate so as to form a tube-like passageway for receiving and containing one of said solid components;

(f) moving said flexible substrate so that the next component receiving region thereof is presented at said work station; and

(g) repeating steps (a) through (f).

The present invention still further provides a packaging arrangement containing the substrate assembly of the invention and a container arrangement which can comprise, for example, a reel, or a box-like container for receiving the substrate which is wound in a boustrophedon pattern to form a plurality of layers.

The present invention still further provides an apparatus for producing the packaging arrangement comprising reel means for storing and presenting the substrate assembly of the invention;

means for paying out a predetermined length of substrate assembly from said reel means, said length being equal to or less than the length of said container and defining a layer; and

layering means for disposing a plurality of layers of said substrate assembly in a boustrophedon configuration, said layers being disposed generally parallel to one another.

The present invention still further provides an apparatus for sequentially disposing from a substrate assembly of the invention a plurality of solid components one at a time, at a predetermined work station, the apparatus including means for advancing the substrate to said work station, and actuating means disposed adjacent a first edge of the flexible substrate, having an actuator arm transversely movable with respect to said flexible substrate to enter said tube-like passageway so as to displace and thereby expel said solid component therefrom at said predetermined work station; and means for advancing said substrate such that a second component receiving portion of said substrate, containing a second solid component, is advanced to said work station.

The present invention still further provides a method for dispensing a plurality of solid components at a first work station, from a packaging arrangement of the invention which includes an elongated flexible substrate of the invention comprising the steps of:

advancing said flexible substrate until a first solid component is disposed adjacent said work station;

extending an actuator arm positioned adjacent one edge of said flexible substrate in directions generally transverse thereto, said arm entering said first end of said tube-like passageway so as to displace and thereby expel said solid component from said passageway depositing said solid component at said work station; and

advancing said flexible substrate such that said tubular passageway is removed from said work station, and another tubular passageway containing another solid component is disposed adjacent said work station, so that the steps of actuating said arm to expel said other solid component from said other passageway can be initiated.

Some ways of carrying out the invention in each of its aspects will now be described in detail by way of example, and not by way of limitation, with reference to drawings in which:-

FIG. 1 is a perspective view of a flexible substrate assembly according to the invention, shown with an actuator arm for ejecting a solid component from the substrate assembly;

FIG. 2 is a perspective view of another flexible substrate assembly according to the invention shown wound about a reel for transportation;

FIGS. 3 and 4 show alternative embodiments of the flexible substrate assembly according to the present invention;

FIG. 5 is a perspective view of a flexible substrate assembly providing substantially enclosed containment of solid components. The substrate is wound in a boustrophedon pattern for ready storage in a box-like shipping container;

FIG. 6 is a perspective view showing the flexible substrate assembly of the present invention being festooned or folded to form the continuous web of Fig. 5;

FIGS. 7a, 7b are plan and elevation views of an apparatus for producing the packaging arrangement of Figs. 2 to 4.

FIGS. 8a, 8b are plan and elevation views of an apparatus for producing the packaging arrangement of Figs. 1; and

FIGS. 9a, 9b show plan views of two arrangements for dispensing solid members contained in the packaging arrangement of Fig. 5.

Turning now to the drawings in which like elements are referenced alike, Fig. 1 shows a flexible substrate assembly 10 containing a plurality of solid components such as electrical connectors, or housings for electrical components or the like, designated generally by reference numeral 12. Components 12 are contained within tubular passageways 14 formed in the double layer laminated flexible substrate carrier portion 16 of assembly 10. Carrier 16 is formed of two aligned, continuous flexible sheets 18, 20 which have parallel overlying edges 18a, 20a and 18b, 20b. Sheets 18, 20 may be formed of any flexible material such as mylar, polyethylene, or polyvinyl chloride. Sheets 18, 20 are joined to each other along seam lines 24 arranged on either side of the passageway 14. Seams 24 are formed by joining aligned pairs of opposed component receiving region end portions using any convenient method, such as heat sealing or adhesives, but preferably by using conventional ultrasonic welding techniques. In its fully fabricated form, substrate assembly 10 is comprised of an alternating series of first and second portions P1 and P2 respectively, the first component receiving portions P1 containing the tubular passageways and the second spacer portions P2 containing the remainder of the assembly located between those passageways. With reference to the lower substrate 20, the substrate is comprised of an alternating succession of first and second portions (aligned with P1, P2, respectively) wherein compnents 12 are disposed on component receiving portions P1. The portions 18' of upper sheet 18 comprise flexible straps which are disposed adjacent portions P1 having ends joined along seams 24 to lower sheet 20, to form the completion of tubular passageways 14. It will be readily appreciated that although sheet 18 is shown as having a width identical to the width of lower sheet 20, sheet 18 could be narrower than sheet 20 and could be aligned to the center or to either side of that sheet.

Also shown in Fig. 1 are actuator arms 30 which comprise, for example, armatures of solenoids 32 which are located adjacent one side of substrate assembly 10. Substrate assembly 10 includes a plurality of indexing apertures 36 which engage the teeth of a drive wheel 38, to provide precise linear advancement of assembly 10. Apertures 36 could be replaced by notches formed by lancing an edge of sheet 20 to form indexing flaps which are thereafter drifted to displace the flaps from the plane of sheet 20. Substrate assembly 10 is readily and accurately indexed so that tubular passageway 14 is aligned with actuator arm 30, whereupon actuator arm 30 is extended to enter passageway 14, thereby displacing and ejecting component 12. It can be seen that the arrangement being described readily provides an accurate placement of a continuous succession of predeterminedly oriented solid members.

Fig. 2 shows an alternative embodiment 40 of the substrate assembly, wherein a single sheet of flexible substrate material 42 has straps 44 struck out therefrom to form tubular passageways 46 for containing a continuous succession of solid components 12. Straps 44 have a first end 44a which is joined to the substrate 42 with a living hinge, and a second free end 44b having ears 48 which are joined to substrate 42 by any suitable technique such as ultrasonic welding. As can be seen, substrate 40 is comprised of an alternating succession of first component receiving portions 50 (upon which the solid members are disposed, and which form the lower portion of tubular passageways 46) and second spacer portions 52 which are disposed between the first portions 50. As indicated in Fig. 2, the completed substrate assembly, with components inserted, can be wound about a reel 54, to provide a convenient packaging assembly. When the substrate assembly is unreeled and indexed to a predetermined position adjacent a dispensing work station, actuator arms (such as those shown in Fig. 1) can be utilized to displace and thereby eject solid components 12 from substrate assembly 40, at the desired position.

Referring now to Fig. 3, a flexible substrate assembly 60 is shown comprising a sheet of flexible substrate material 62 from which straps 64 are struck in a  outward direction by a rolling cutting die or the like conventional apparatus. Straps 64 have a first end 64a joined to substrate 62 with a living hinge, and a second free end 64b which, upon folding flap 64, is joined to substrate 62 by ultrasonic welding, for example, to form a seam 66. As can be seen in Fig. 3, flexible substrate 62 comprises an alternating succession of first component receiving portions 70 forming a portion of tubular passageways 69, for receiving solid members 68, and second spacer portions 72 located between the first portions 70. As shown in the right hand portion of Fig. 3, solid component 68 comprises an electrical connector having a body 74, and plurality of outwardly extending pin-like projections 76 having free ends 78. To prevent damage or misalignment of the

0182504

terminals 76 during transportion, and to prevent the piercing of straps 64 by those terminals, a rigid spacer member 80 is located adjacent terminals 76, having an upper surface 82 which projects slightly above, or is at a same level are the free ends 78 of terminal 76. When fully assembled, straps 64 will contact spacer member 80, rather than free ends 78 of terminals 76.

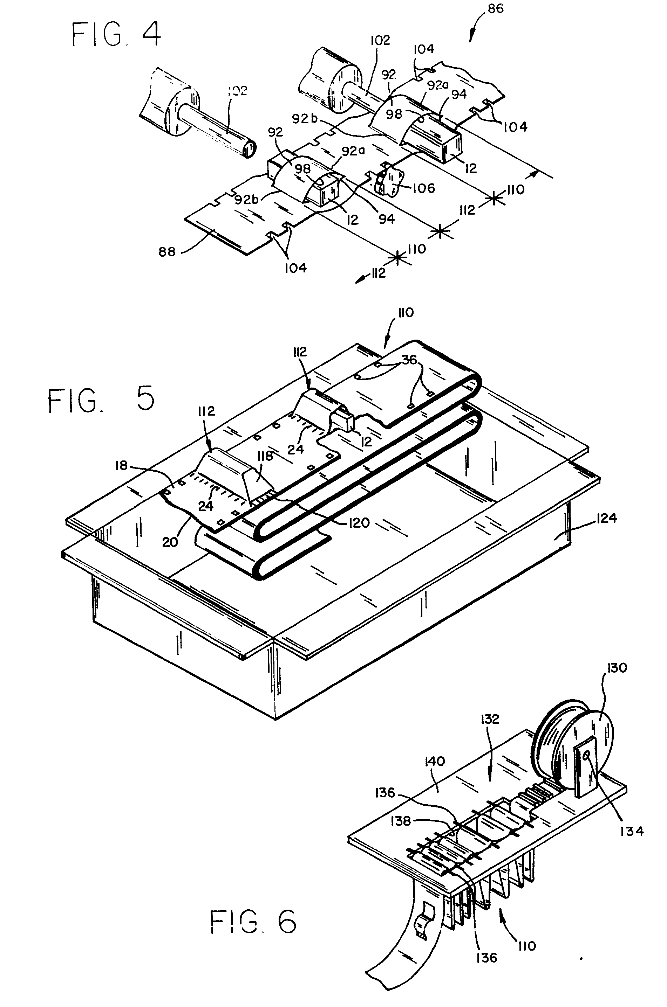

Turning now to Fig. 4, a flexible substrate assembly 86 is comprised of a flexible substrate sheet 88 from which straps 92 are formed by a plurality of spaced apart slits 94. Straps 92 have first and second ends 92a, 92b joined to flexible substrate 88 to form tubular passageways 98 for containing solid components 12. As can be seen in this embodiment, no ultrasonic welding or other bonding is required to join straps 92 to substrate 88. Also shown in Fig. 4 is a positioning work station having actuator arms 102 which enter tubular passageways 94 to displace and thereby eject components 12 from carrier substrate assembly 86, at a predetermined location. Substrate assembly 86 has a plurality of spaced-apart apertures or notches 104 which engage drive wheel 106 to provide advancement of substrate assembly to a desired work station. As can be seen in Fig. 4, flexible substrate 88 comprises an alternating succession of first component receiving portions 110 which form the lower portion of tubular passageways 94 for containing solid components 12, and second spacer portions 112 located between the first portions 110.

Referring now to Fig. 5, a substrate assembly 110 is shown comprising a continuous succession of container portions 112. Substrate assembly 110 is conveniently comprised of the substrate assembly 10 of Fig. 1, wherein the ends of each tubular passageway are closed by joining adjacent edges of upper and lower substrate sheets 18, 20 to form a closed end 118. In the preferred embodiment, upper and lower substrate sheets 18, 20 are brought together at their ends, being ultrasonically welded to form a seam 120 at each end of the tubular passageway.

Also shown in Fig. 5 is a packaging arrangement wherein the substrate assembly 110 is laid in a back-and-forth, boustrophedon, or festooned arrangement, for ready containment in a box-like container 124. This packaging arrangement could readily accommodate the other substrate assembly embodiments described herein.

Fig. 6 shows a workstation for folding the substrate assembly 110 of Fig. 5. The completed substrate assembly 110 has conveniently been wound onto a takeup reel 130. At folding station 132, the takeup reel 130 is disposed on a removeable reel axis 134, so that the plurality of substrate portions of predetermined length can be draped over moveable fold pins 136 disposed to overlie a rectangular slot 138 in folding station plate 140. The moveable fold pins 136 can be moved away from the reel 130 after the material is draped over pin 136 at regular time intervals, to fold the substrate assembly upon itself in a boustrophedon pattern, generally designated by the numeral 125 in Fig. 5. For this purpose, the substrate is folded such that each layer has a length approximately equal to the length L of box 124 as shown in Fig. 5.

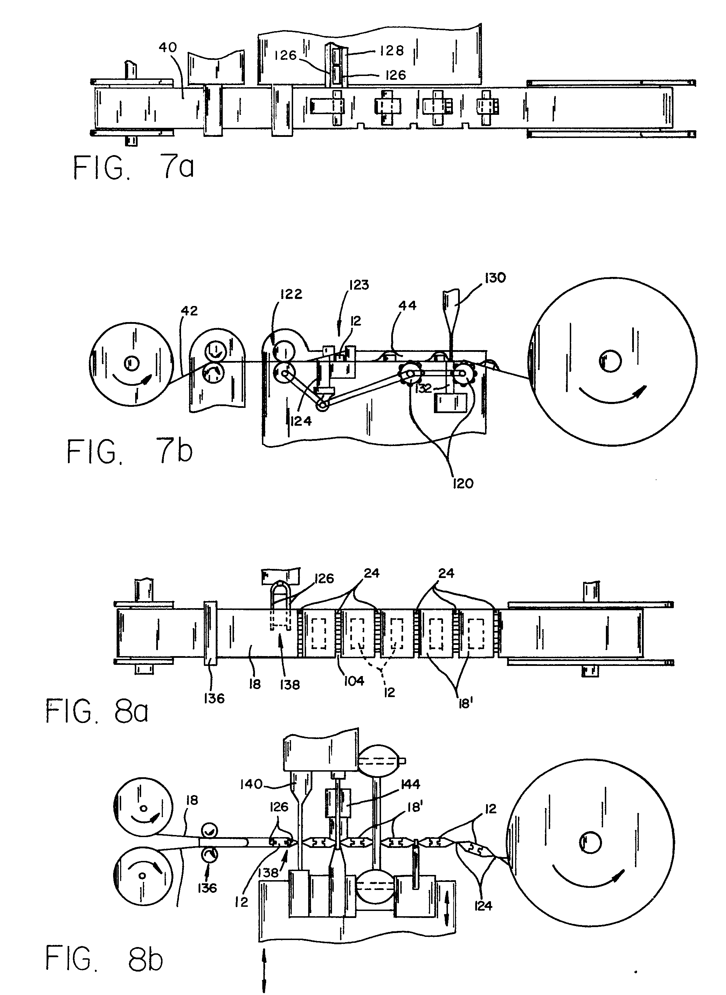

Turning now to Figs. 7 and 8, a method and apparatus for constructing the aforementioned flexible substrate assemblies will be shown. Figs. 7a, 7b show a work station for fabricating a flexible substrate assembly of Fig. 2, 3 or 4. The flexible substrate assembly 42 of Fig. 2, is advanced from left to right in Figs. 7a, 7b by cog drive wheels 120 which engage indexing notches or apertures formed in the substrate. As substrate 40 is advanced past a rotary die unit 122, straps 44 are struck from substrate 40, and upon further advancement are located adjacent an insert station 123 where a strap lifter 124 raises strap 44 from the plane of substrate 42, to allow positioning of a component 12, therebetween. Component 12 is expelled from an assembly machine not shown in the Figures, being introduced along exit track 128, where it is grasped at each side by reciprocating loading arms 126. Arms 126, which grasp the connector at either side in a vice-like fashion, are extended so as to be positioned between strap 44 and substrate 42. Substrate assembly 40 is thereafter advanced such that the ears 48 are disposed between ultrasonic welding horn 130 and its related anvil 132 for bonding to substrate 40.

The above method and apparatus also applies to the flexible susbtrate assemblies shown in Figs. 3 and 4. However, the ultrasonic welding position is not required for the connector assembly 86 of Fig. 4. After its formation in rotary die 122, strap 92 is raised at station 124 and solid member 100 is inserted in tubular passageway 94.

Turning now to Figs. 8a, 8b a fabrication station similar to that of Figs. 7a, 7b is shown, for fabricating the flexible substrate assembly 10 of Fig. 1. Upper and lower substrate sheets 18, 20 are advanced by a feed position 136 to an insertion station 138 where solid component 12 is spatially oriented by the insertion arms 126 of a shuttle insertion mechanism 128, similar to that of Figs. 7a, 7b. Thereafter, upper and lower flexible substrate sheets 18, 20 are joined together by ultrasonic welding horn 140, which joins a first side of tubular passageway 14. Thereafter, flexible substrate sheets 18, 20 are advanced so that the other seam 24 of tubular passageway 14 can be formed at the same welding station 140. Drive notches are formed in the substrate assembly at notching die station 144 which lances and drifts the notched portions. Thereafter, flexible substrate assembly is located to a pickup reel or a folding work station such as the work station 132 of Fig.6.

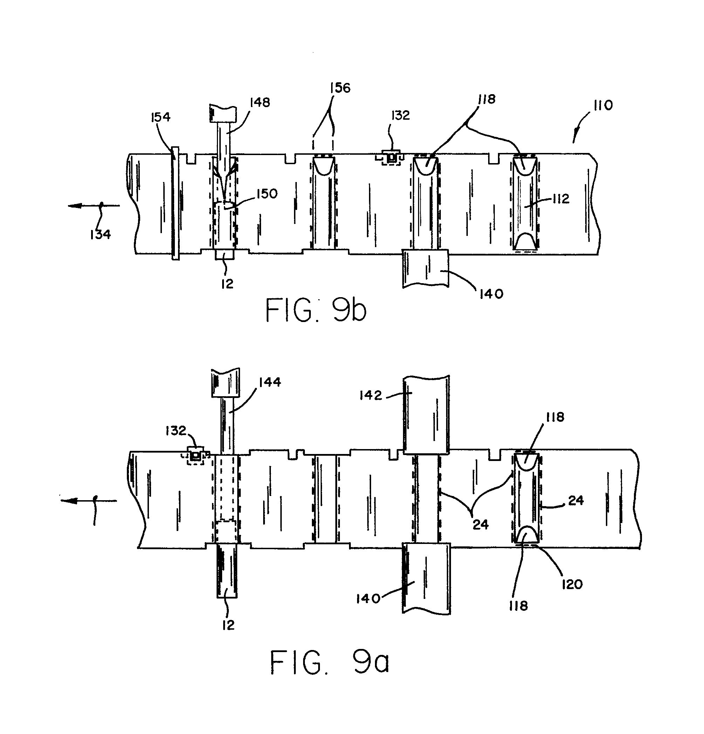

Turning now to Figs. 9a, 9b two work station embodiments for removing solid components from the flexible substrate assembly 110 of Fig. 5 are shown. Each work station includes a drive means 132 for advancing the flexible substrate assembly 110 in predetermined amounts in the direction of arrow 134. Fig. 9a shows notching blades 140, 142 for notching or slitting the edges of flexible substrate assembly 110 so as to open each end 118 of containing portions 112. Thereafter, an actuator arm 144 such as that shown in Figs. 1, 3 or 4 can be employed to eject component 12 from the flexible substrate assembly.

Fig. 9b shows an alternative arrangement for ejecting the solid members, wherein only one side of the container is notched by notching blade 140. The opposing closed end of the container is pierced by an actuator arm 148 which contains a knife blade tip 150 for slitting the upper portion of container cavity 112. As actuator arm 148 enters the container portion 112, component 12 is displaced and thereby ejected. An alternative method of dispensing component 12 is indicated by knife blade 154 which slits or opens one side of container portion 112 by cutting just inside the welded seam portion 24, along dotted lines 156 as shown in Fig. 9b.

Although the method of forming the flexible substrate packaging assembly has included the formation of the flexible substrate around a spatially positioned component, it will be readily appreciated by those skilled in the art that (with the exception of the substantially enclosed containers of Fig. 5,) the flexible substrate could be formed first, with the solid member being thereafter inserted. For example, in the arrangement of Fig. 1, flexible substrate sheets 18, 20 could be bonded together to form tubular passageways 14, whereupon the flexible substrate carrier thus formed would be stored in a convenient manner, such as on a reel or folded in a boustrophedon pattern for storage in a box. Thereafter, the carrier assembly could be extracted and solid members inserted within the tubular passageways.

It will also be appreciated by those skilled in the art that the relative length of the strap and substrate first portions in each of the embdoments set forth above, need not be of equal length. For example, the straps could be longer than the first portions of the substrate which they adjoin.

In each of the embodiments described above, the solid component can be readily ejected from either end of the tubular passageway. This is an important feature when the solid components having axes of symmetry that give the components a "reversible" configuration, depending upon the end of the component considered.

CLAIMS:

1. A flexible substrate assembly (10 or 40 or 60 or 86) characterized by

an elongated flexible substrate (16 or 42 or 62 or 88) of predetermined width having a plurality of spaced-apart component receiving regions;

a plurality of parallel elongated solid components (12 or 68) having a predetermined height and a length no greater than the width of said substrate, spaced-apart on said substrate, one on each region; and

a plurality of flexible strap means (18' or 44 or 64 or 92), each having one end adjacent each region on one side thereof and a second end adjacent the opposite side of said region integrally joined by a connecting portion overlying said region to form a substantially continuous transverse tube-like passageway of substantially constant cross-sectional configuration and a height substantially equal to the greatest height of said component, for receiving and containing said components.

2. The assembly of claim 1 wherein said substrate includes a plurality of spaced-apart spacer regions, one lcoated between each pair of adjacent component receiving regions.

3. The assembly of claim 2 wherein the connecting portion of said strap means (64) is struck out from each spacer region leaving an opening therein and the second end is a free end secured to the substrate in a direction away from said opening.

4. The assembly of claim 2 wherein the connecting portion of said strap means (44 or 92) is struck out from each component receiving region.

5. The assembly of claim 1 wherein the first and second ends of each strap means are bonded to said substrate along first and second spaced apart seams (24) on opposite sides of each component securing region.

6. The assembly of claim 5 wherein said substrate includes two aligned continuous flexible sheets (18, 20) and said sheets are joined together along said seams (24) to form substantially continuous tube-like passageways extending between adjacent seams for receiving and containing ones of said solid components, said passageways having a substantially constant cross-sectional configuration and a height substantially equal to the greatest height of said solid components.

7. The assembly of any preceding claim wherein said solid component (68) includes a solid body (74)

0182504

- 19 -

with a plurality of spaced apart rigid pin-like projections (76) extending therefrom, said projections having a predetermined length and a free end, and said assembly further includes rigid spacer means (80) disposed adjacent said projections and having a surface located adjacent said free ends of said projections to prevent contact of said free ends with said connecting portion of said strap means.

8. The assembly of any preceding claim further including indexing means (36 or 164) formed in said substrate to provide accurate positioning of said substrate assembly with respect to a work station.

9. A method of manufacturing a flexible substrate assembly as claimed in claim 1 from a source of said elongated flexible substrate comprising the steps of:

(a) presenting a component receiving region of said substrate at a work station;

(b) striking the connecting portion of said flexible strap means (44 or 64) from said substrate so that the first end remains attached to the substrate and the second end is a free end;

(c) placing said solid component on the component receiving region;

(d) positioning the free end of the strap means over the component; and

(e) joining the free end of said strap means to said flexible substrate so as to form a substantially continuous transverse tube-like passageway having a substantially constant cross-section.

10. The method of claim 9 wherein said substrate includes a plurality of spaced-apart spacer regions, one located between each pair of adjacent component receiving regions, the method including striking out said connecting portion of said strap means from each spacer region.

11. The method of claim 9 wherein said substrate includes a plurality of spaced-apart spacer regions, one located between each pair of adjacent component receiving regions, the method including striking out said connecting portion of said strap means (92) from each component receiving region.

12. A method of manufacturing a flexible substrate assembly as claimed in claim 6 from a source of said continuous flexible sheets comprising the steps of:

(a) aligning the two sheets (18, 20) in an elongated parallel spaced-apart relationship so that an opposed pair of component receiving regions are presented at a work station;

(b) joining the sheets along a first seam to define the first end of a strap means (18');

(c) placing a solid component between said component receiving regions of said first and said second substrates;

(d) joining the sheets along a second seam to define the second end of the strap means (18') to form a transverse tube-like passageway having a substantially constant cross-sectional configuration and a height substantially equal to the greatest height of said components;

(e) moving the sheets so that the next pair of opposed component receiving regions is presented at the work station; and

(f) repeating steps (a) through (e).

13. The method of any of claims 9 to 12 further including the step of forming a plurality of indexing means in said substrate assembly to provide accurate positioning of said substrate assembly at a predetermined work station.

14. The method of claim 13 wherein said substrate assembly includes first and second spaced apart edges, said method of forming said indexing means comprising the steps of lancing at least one edge of said substrate assembly to form a plurality of timing flaps; and drifting said timing flaps for displacement from said substrate assembly, thereby forming a plurality of notches (164) adjacent said edge.

15. The method of claim 14 wherein said solid components include a solid body with a plurality of spaced apart rigid pin-like projections extending therefrom, said projections having a predetermined length and a free end, said method further comprising the step of inserting a rigid spacer means (80) having a contact surface adjacent said projections such that said contact surface of said spacer means is disposed adjacent said free ends of said projections to prevent contact of said free ends with said strap means.

16. A packaging arrangement comprising a substrate assembly as claimed in any one of claims 1 to 8 and means (54 or 124) containing said substrate assembly, said containing means surrounding said susbtrate assembly.

17. The packaging arrangement of claim 16 wherein said containing means comprises a reel-like member (54) about which said flexible substrate is wound so as to be contained thereon for transport.

18. The packaging arrangement of claim 16 wherein the container (124) has a length L and said substrate assembly being folded over and back upon itself in a boustrophedon pattern to define a plurality of stacked layers within the container with said layers having a length substantially equal to L.

19.  Apparatus for producing a packaging arrangement as claimed in claim 18 comprising

reel means (130) for storing and presenting the substrate assembly (10 or 40 or 60 or 86);

means for paying out a predetermined length of substrate assembly from said reel means, said length defining a layer which is equal to or less than the length of said container (124); and

layering means for disposing a plurality of layers of said substrate assembly from said reel means, said length defining a layer which is equal to or less than the length of said container; and

layering means for disposing a plurality of layers of said substrate assembly in a boustrophedon configuration, said layers being disposed generally parallel to one another.

20.  The apparatus of claim 19 further including means for manufacturing said substrate assembly, said substrate assembly manufacturing means comprising:

a work station whereat said scrap means is

positioned adjacent said component receiving region, a solid component is disposed between said flexible substrate and said strap means to form a completed substrate assembly; and

a reel means for collecting the completed substrate assembly.

21. The apparatus of claim 20 wherein said means for manufacturing said substrate assembly further comprises joining means for joining a free end of said strap means to said substrate adjacent said component receiving region so as to form said tube-like passageway.

22. The apparatus of claim 19 wherein said substrate assembly includes first and second spaced-apart edges, said apparatus further including means for forming a plurality of indexing means adjacent at least one said edge, said indexing means providing means for accurately positioning said substrate assembly with respect to a predetermined work station.

23. Apparatus for dispensing a plurality of solid components, one at a time, at a predetermined work station from a flexible substrate assembly (10 or 40 or 60 or 86) as claimed in any of claims 1 to 8 comprising:

means for presenting a component receiving region of said substrate at said work station;

ejecting means disposed adjacent a first edge of said flexible substrate and having an actuator arm transversely movable with respect to said flexible substrate to enter said tube-like passageway so as to displace and thereby expel said solid component therefrom at said predetermined work station; and

means for advancing said substrate such that another component receiving portion of said substrate, containing another solid component, is advanced to said work station.

24. The apparatus of claim 23 wherein said arm further includes cutting means for cutting said strap in directions transverse to said component receiving region to thereby assist in expelling said solid component from said tube-like passageway.

25. The apparatus of claim 23 wherein said strap means is joined to said substrate along first and second spaced-apart seams, said apparatus further comprising slitting means for slitting said flexible substrate adjacent one of said seams so as to release said solid component contained within said tubular passageway.

26. The apparatus of claim 23 wherein said substrate assembly is stored in a container means, said apparatus further comprising means for removing a predetermined amount of said substrate assembly from said container means.

27. A method for dispensing a plurality of solid components at a first work station from a flexible substrate assembly (10 or 40 or 60 or 86) as claimed in any of claims 1 to 8 comprising the steps of:

(a) presenting a first component receiving region containing a solid component at said work station;

(b) extending an ejector arm in directions generally transverse to said substrate, said arm entering a first end of the tube-like passageway at said work station so as to displace and thereby expel said solid component from said passageway, thereby presenting said solid component at said work station; and

(c) advancing said flexible substrate such that said tubular passageway is removed from said work station, and another tubular passageway containing another solid component is presented at said work station; and

(d) repeating steps (b) and (c).

28. The method of claim 27 wherein said ejector arm includes cutting means, and said step of extending said actuator arm includes the step of cutting said strap means with said cutting means in directions transverse to said substrate as said arm is extended within said tube-like passageway, to aid in expelling said solid component from said passageway.

29. The method of claim 27 wherein said strap means is joined to said component receiving region and said method further comprises the step of slitting said flexible substrate adjacent one of said seams, opening said passageway to aid in expelling said solid component therefrom.

FIG. 1

FIG. 2

FIG. 3

0182504

FIG. 4

FIG. 5

FIG. 6

FIG. 7a

FIG. 7b

FIG. 8a

FIG. 8b

0182504

FIG. 9b

FIG. 9a